## Europäisches Patentamt
## European Patent Office
## Office européen des brevets

(19)

(11) Veröffentlichungsnummer: **0 191 439**
**B1**

(12) **EUROPÄISCHE PATENTSCHRIFT**

(45) Veröffentlichungstag der Patentschrift:
04.10.89

(21) Anmeldenummer: 86101629.3

(22) Anmeldetag: 07.02.86

(51) Int. Cl.⁴: **H01J 37/09**, H01J 37/317,
H01J 37/30, H01J 9/14

(54) Aperturblende mit zellenförmiger Mehrlochstruktur und Austastelektroden zur Erzeugung einer Mehrzahl von individuell austastbaren Korpuskularstrahlsonden für ein Lithografiegerät.

(30) Priorität: 12.02.85 DE 3504705

(43) Veröffentlichungstag der Anmeldung:
20.08.86 Patentblatt 86/34

(45) Bekanntmachung des Hinweises auf die Patenterteilung:
04.10.89 Patentblatt 89/40

(84) Benannte Vertragsstaaten:
DE FR GB IT NL

(73) Patentinhaber: Siemens Aktiengesellschaft,
Wittelsbacherplatz 2, D-8000 München 2(DE)

(72) Erfinder: Lischke, Burkhard, Prof. Dr., In der Heuluss 13,
D-8000 München 82(DE)

(56) Entgegenhaltungen:
EP-A- 0 043 351

IBM TECHNICAL DISCLOSURE BULLETIN, Band 26,
Nr. 2, Juli 1983, Seiten 690-691, Armonk, New York, US;
U. BEHRINGER et al.: "Method of producing a thin-film
silicon diaphragm used in electron and ion microscopy"

## Beschreibung

Die Erfindung bezieht sich auf eine Aperturblende mit zeilenförmiger Mehrlochstruktur und Austastelektroden zur Erzeugung einer Mehrzahl von individuell austastbaren Korpuskularstrahlsonden für ein Lithografiegerät nach dem Oberbegriff des Patentanspruchs 1 sowie auf Verfahren zur Herstellung derselben.

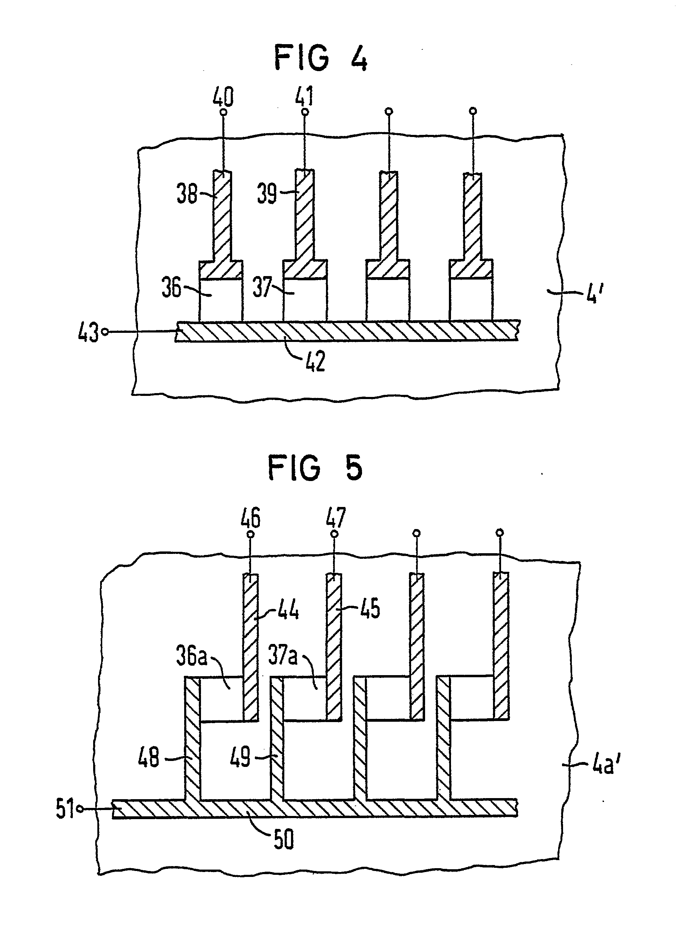

Eine Aperturblende dieser Art ist aus den IEEE Transactions on Electron Devices, Vol. ED-26, No. 4, April 1979, S. 663-674, insbesondere Fig. 4, bekannt. Dabei bestehen die Austastelektroden aus randseitig zu den Ausnehmungen der Mehrlochstruktur liegenden Plattenpaaren, die über Koaxialleitungen mit Austastspannungen beaufschlagt werden, so daß die durch die Ausnehmungen hindurchtretenden Korpuskularstrahlsonden mittels der elektrostatischen Felder zwischen den Plattenpaaren seitlich in Richtung auf eine Austastblende abgelenkt werden. Diese Aperturblende ist jedoch technisch sehr aufwendig ausgebildet, wobei der Aufwand mit der Anzahl der Ausnehmungen, d.h. mit der Anzahl der verwendeten Korpuskularstrahlsonden, stark ansteigt.

Der Erfindung liegt die Aufgabe zugrunde, eine Aperturblende der eingangs genannten Art anzugeben, die auch für eine Vielzahl von Korpuskularstrahlsonden ausgelegt werden kann, ohne daß ihre Herstellung einen besonderen technischen Aufwand erfordert. Das wird erfindungsgemäß durch eine Ausbildung der Aperturblende nach dem kennzeichnenden Teil des Patentanspruchs 1 erreicht.

Der mit der Erfindung erzielbare Vorteil liegt insbesondere darin, daß sowohl die Ausnehmungen als auch die mit diesen zusammenwirkenden Austastelektroden in einer einfachen Planartechnik hergestellt werden können, wobei sich der Aufwand auch für eine sehr große Anzahl von Ausnehmungen, d.h. für eine sehr große Anzahl von Korpuskularstrahlsonden, in erträglichen Grenzen hält.

Die Ansprüche 2 bis 7 sind auf bevorzugte Ausgestaltungen und Weiterbildungen der Aperturblende nach der Erfindung gerichtet, während die Ansprüche 8 und 9 bevorzugte Verfahren zur Herstellung derselben betreffen.

Die Erfindung wird nachfolgend anhand der Zeichnung näher erläutert. Dabei zeigen:

Fig. 1 ein Lithografiegerät mit einer schematisch dargestellten, ersten Ausführungsform einer Aperturblende nach der Erfindung,
Fig. 2 eine Draufsicht auf die erfindungsgemäße Aperturblende nach Fig. 1,
Fig. 3 eine zusammen mit der Aperturblende nach Fig. 2 einsetzbare, zusätzliche Aperturblende,
Fig. 4 eine zweite Ausführungsform der erfindungsgemäßen Aperturblende,
Fig. 5 eine zusammen mit der Aperturblende nach Fig. 4 einsetzbare, zusätzliche Aperturblende, und die
Figuren 6 bis 10 einzelne Schritte bei der Herstellung von Aperturblenden nach den Figuren 2 bis 5.

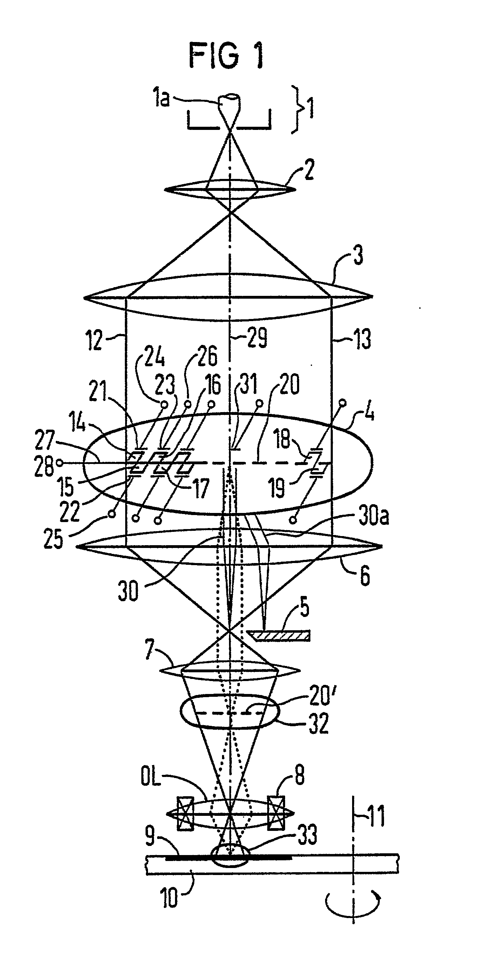

Das in Fig. 1 schematisch dargestellte Lithografiegerät umfaßt eine Elektronenstrahlquelle 1 mit einer Einkristallbolzenkathode 1a, Kondensorlinsen 2 und 3, eine Aperturblende 4, eine Austastblende 5, eine aus Linsen 6, 7 und einer Objektivlinse OL bestehende Abbildungsoptik und ein Ablenksystem 8, unter dem sich ein zu strukturierender Körper 9, insbesondere Halbleiterkörper befindet. Dieser ist auf einem Tisch 10 befestigt, der zweckmäßigerweise um eine vertikale Achse 11 drehbar gelagert ist.

Die aus der Kathode 1a austretenden Elektronenstrahlen werden durch die Kondensorlinsen 2 und 3 zu einem Strahl zusammengefaßt, der durch die zueinander parallelen Randstrahlen 12 und 13 begrenzt ist. Die scheibenförmig ausgebildete Aperturblende 4 ist mit einer zeilenförmigen Mehrlochstruktur versehen. Dabei sind rechteckige oder quadratische Ausnehmungen 14 bis 19 vorgesehen, die jeweils von einer mittleren, gestrichelten Linie 20 ausgehen und abwechselnd nach der einen und der anderen Seite versetzt sind. Im einzelnen liegen die Ausnehmungen 14, 16 ... 18 auf der einen und die Ausnehmungen 15, 17 ... 19 auf der anderen Seite von 20. An den der Linie 20 gegenüberliegenden Seite der Ausnehmungen befinden sich jeweils Austastelektroden 21 bis 23, die mit Anschlüssen 24 bis 26 verbunden sind. Eine weitere Elektrode 27 erstreckt sich entlang der Linie 20 und stellt eine für alle Ausnehmungen gemeinsame Gegenelektrode dar. Sie ist mit einem Anschluß 28 verbunden.

Mittels der Aperturblende 4 wird nun aus dem durch die Randstrahlen 12 und 13 begrenzten Elektronenstrahl eine Vielzahl von Elektronenstrahlsonden gebildet. Jede derselben besteht aus einem durch eine der Ausnehmungen 14 bis 19 hindurchtretenden Teil des genannten Elektronenstrahls. In Fig. 1 ist eine Elektronenstrahlsonde, die durch eine in der Längsachse 29 des Lithografiegeräts liegende, im einzelnen aber nicht dargestellte, Ausnehmung hindurchtritt, mit 30 bezeichnet. Legt man an die zu dieser Ausnehmung gehörige Austastelektrode, die mit 31 angedeutet ist, und an die Gegenelektrode 27 eine Spannung durch die 31 auf ein positiveres Potential gelegt wird als 27, so wird die Sonde 30 in die Lage 30a abgelenkt, und dadurch von der Austastblende 5 aufgefangen, so daß sie aus dem weiteren Strahlengang ausgeblendet ist. Dabei ist zu bemerken, daß die Ablenkung der Sonde 30 eigentlich hinter die Bildebene von Fig. 1 erfolgt, wobei dann die Lage der abgelenkten Sonde 30a unterhalb der Linse 6 parallel zur Bildebene von Fig. 1, aber hinter ihr zu denken wäre. Dementsprechend muß die Austastblende 5 auch hinter der Bildebene von Fig. 1 angeordnet sein. Lediglich aus Gründen einer einfachen Darstellung wurde in Fig. 1 angedeutet, daß die Ablenkung von 30 nach rechts erfolgt und die Austastelektrode 5 in der Bildebene von Fig. 1 liegt.

Jede nicht abgelenkte Sonde, z.B. 30, steht zur Belichtung der Oberfläche des Körpers 9 oder eines auf diesem aufgebrachten Resists zur Verfügung. Zur Ausblendung einer gemäß Fig. 1, z.B. durch die Ausnehmung 14, gebildeten Sonde, wird der Elektrode 21 eine positive Spannung zugeführt, während die Elektrode 27 auf Bezugspotential gelegt ist. Soll eine durch die Ausnehmung 15 gebildete Sonde ausgeblendet werden, so wird an die Elektrode 22 eine negative Spannung gelegt. Bei Ausbildung von 5 als Schlitzblende, die sich sowohl vor als auch hinter der Bildebene von Fig. 1 befindet, ist an 22 auch eine positive Spannung zulässig.

Wie sich aus dem eingezeichneten Strahlengang ergibt, werden die Sondenquerschnitte in der Ebene der Aperturblende 4, die durch die Abmessungen der Ausnehmungen, z.B. 14, gegeben sind, mittels der Linsen 6 und 7 in eine Ebene 32 verkleinert abgebildet, was einer Reduzierung der Linie 20 auf eine Linie 20' entspricht. Die Ojektivlinse OL bildet dann die Querschnitte der Elektronenstrahlsonden verkleinert auf die Oberfläche des Körpers 9 ab, was durch 33 angedeutet ist.

Die Strukturerzeugung auf dem Körper 9 erfolgt nach Fig. 1 so, daß die Gesamtheit aller nicht abgetasteten Elektronenstrahlsonden nach dem Belichten der durch sie getroffenen Punkte des Körpers 9 oder eines diesen bedeckenden Resists beispielsweise mittels des Ablenksystems 8 in einer zur Projektion der Linie 20 etwa senkrechten Richtung relativ zum Körper 9 bewegt wird, und zwar um eine Sondenabmessung. Die so aufgesuchte benachbarte Sondenzeile wird dann in analoger Weise belichtet. Durch individuelle Ansteuerung der Austastelektroden, z.B. 21, kann ein beliebiges Belichtungsmuster auf der Oberfläche von 9 erzeugt werden, dessen kleinstes Strukturdetail der Querschnittsabmessung einer Sonde, gemessen auf der Oberfläche von 9, entspricht.

Der gepunktete Strahlengang in Fig. 1 veranschaulicht die Abbildung der Ausnehmungen 14 usw. der Aperturblende 4 auf die Oberfläche des Körpers 9.

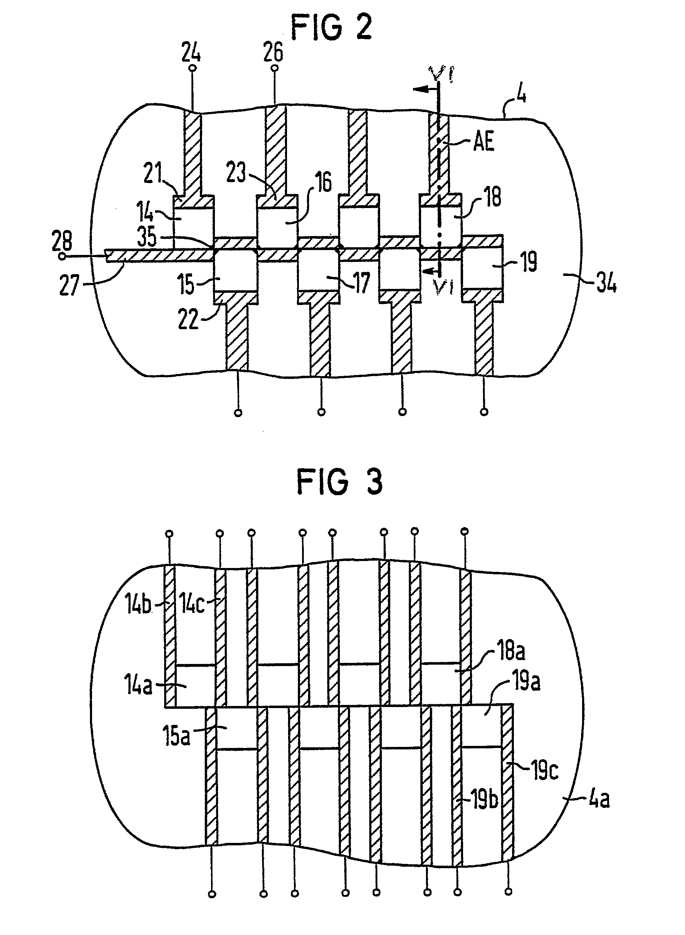

Fig. 2 zeigt die in Fig. 1 schematisch angedeutete Ausführungsform der Aperturblende 4 im einzelnen. Dabei ist eine hochohmige Substratfolie 34, z.B. aus Silizium, mit den bereits beschriebenen Ausnehmungen 14 und 19 versehen. Die zur Sondenaustastung dienenden Elektroden 21, 22, 23 usw. sind als endseitig verbreiterte Leiterbahnen ausgeführt, die z.B. aus Gold bestehen. Die gemeinsame Elektrode 27 besteht vorzugsweise ebenfalls aus Gold und verläuft mäanderförmig zwischen den Ausnehmungen, wobei sie mit genügend breiten Zwischenstegen 35 versehen ist, um einen guten Kontakt zwischen ihren einzelnen Teilen zu erreichen. Die der Elektronenstrahlquelle 1 zugekehrte Oberfläche von 4 ist außerhalb der Lochstrukturen mit einer leitenden Belegung versehen, über die die auftreffenden Elektronen abgeleitet werden. Diese leitende Belegung ist von den Leiterbahnen durch eine isolierende Zwischenschicht getrennt.

Nach einer vorteilhaften Weiterbildung kann die Aperturblende 4 durch eine weitere Aperturblende 4a gemäß Fig. 3 ergänzt werden. Diese besteht auch aus einer hochohmigen Substratfolie, z.B. aus Silizium, und weist Ausnehmungen 14a bis 19a auf, die bei einer genauen gegenseitigen Justierung der Blenden 4 und 4a mit den Ausnehmungen 14 bis 19 zusammenfallen. Randseitig zu den Ausnehmungen 14a bis 19a sind jeweils zwei Elektroden 14b, 14c bis 19b, 19c vorgesehen, die mit Anschlüssen verbunden sind. An diese können Spannungen angelegt werden, die eine Ablenkung der Elektronenstrahlsonden parallel zur Längsrichtung der zeilenförmigen Mehrlochstruktur bewirken, um optische Fehler (z.B. Öffnungsfehler, der Kondensatorlinsen, Verzeichnungen der Abbildungsoptik usw.) zu korrigieren. Die Elektrodenstrukturen von 4a sind ebenfalls als Leiterbahnen ausgeführt und bestehen z.B. aus Gold.

Mit besonderem Vorteil können die in der beschriebenen Weise ausgebildeten Aperturblenden 4 bzw. 4a für eine große Anzahl von Ausnehmungen 17 usw. ausgelegt sein. Beispielswweise sind 2048 Ausnehmungen denkbar, mit denen eine entsprechende Anzahl von Elektronenstrahlsonden erzeugt werden. Geht man von einer quadratischen Form der Ausnehmungen 17 usw. mit einer Seitenlänge von 10 µm aus und verkleinert die Sondenabmessung mit Hilfe der Abbildungsoptik um den Faktor 100, so ergeben sich einzelne belichtbare Bildpunkte mit einer Seitenlänge von 0,1 µm. Bei einem Sondenstrom von etwa 5 nA für jede Sonde wird dann bei einer Lackempfindlichkeit $C = 10^{-5} As/cm^2$ eine Belichtungsgeschwindigkeit von etwa 1 cm²/s erreicht, was einem Durchsatz von etwa 50 4"-Halbleiterscheiben pro Stunde entspricht. Die Länge der Mehrfachlochstruktur auf der Aperturblende 4 beträgt dabei etwa 20,5 mm. Mit einer solchen Aperturblende lassen sich z.B. Strukturen im 0,1 µm-Bereich erzeugen, wie sie etwa für integrierte Schaltungen auf GaAs-Basis oder für Komponenten der optischen Nachrichtentechnik, z.B. Gitterstrukturen für Festkörperlaser, erforderlich sind.

Eine andere bevorzugte Ausgestaltung der erfindungsgemäßen Aperturblende ist in Fig. 4 dargestellt und mit 4' bezeichnet. Sie besteht aus einer hochohmigen Substratfolie, z.B. aus Silizium, bei der die einzelnen Ausnehmungen 36, 37, im Gegensatz zur Ausführungsform nach den Figuren 1 und 2 entlang einer Linie liegen, ohne gegeneinander versetzt zu sein. Die Austastelektroden, die randseitig zu den einzelnen Ausnehmungen angeordnet sind, sind auch hier als endseitig verbreiterte Leiterbahnen 38, 39 usw. und mit endseitigen Anschlüssen 40, 41 usw. versehen. Die Leiterbahnen 38, 39 können ebenfalls aus Gold bestehen. Die gemeinsame Gegenelektrode kann hier als eine einfache Leiterbahn ausgebildet sein, die einen endseitigen Anschluß 43 aufweist. Legt man positive Spannungen an die Anschlüsse 40 usw. und hält den Anschluß 43 auf Bezugspotential fest, so können wieder die durch die Öffnungen 36 usw. hindurchtretenden Elektronenstrahlsonden in der beschriebenen Weise ausgeblendet werden. Zweckmäßig sind jeweils zwei benachbarte Ausnehmungen, z.B. 36, 37, um ein ihrer Abmessung in Richtung der Längsachse der Mehrlochstruktur entsprechendes Maß voneinander entfernt. Bei der Belichtung der Oberfläche des Körpers 9 muß dann nach jedem einzelnen Belichtungsvorgang innerhalb der gleichen Zeileneinstellung der Elektronenstrahlsonden eine Verschiebung der letzteren um eine solche Abmessung in Richtung der Längsachse der Mehrlochstruktur erfolgen, damit eine vollständige Belichtung des Körpers 9 gewhrleistet ist. Diese Verschiebung wird mit Vorteil mittels des Ablenksystems 8 vorgenommen.

Die Aperturblende 4' kann durch eine weitere Aperturblende 4a' gemäß Figur 5 ergänzt werden. Diese entspricht in ihrem Aufbau der Aperturblende 4a, wobei im Unterschied zu Fig. 3 die Ausnehmung 36a, 37a usw. so angeordnet sind, daß sie bei einer genauen gegenseitigen Justierung der Blenden 4' und 4a' mit den Ausnehmungen 36, 37 usw. zusammenfallen. Randseitig zu diesen Ausnehmungen sind Elektroden 44, 45 usw. vorgesehen, die mit Anschlüssen 46, 47 usw. verbunden sind. Die Gegenelektroden 48, 49 usw., die den Elektroden 44, 45 usw. jeweils gegenüberliegen, können durch eine gemeinsame Leiterbahn 50 miteiander verbunden werden, die über einen Anschluß 51 mit einer für alle Gegenelektroden gemeinsamen Spannung beaufschlagt wird. Die Aperturblende 4a' dient in Verbindung mit der Blende 4a zur optischen Fehlerkorrektur in der bereits anhand von Fig. 3 beschriebenen Weise.

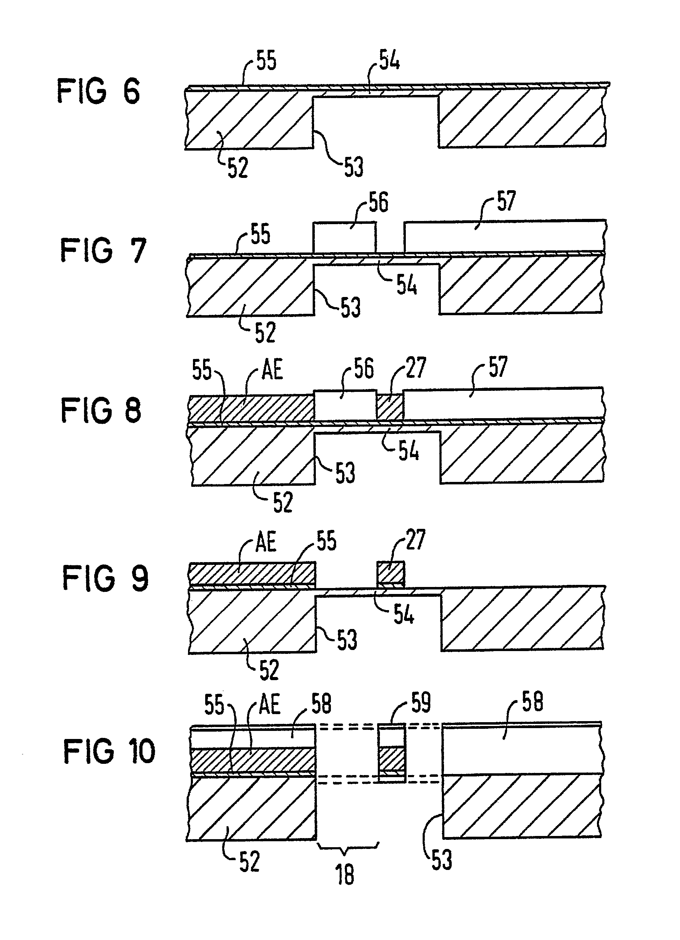

Zur Herstellung einer Aperturblende nach Fig. 2 sei auf Fig. 6 verwiesen, die einen Querschnitt längs der Linie VI - VI von Fig. 2 zeigt. Hierbei wird zweckmäßigerweise so vorgegangen, daß eine Substratscheibe 52, z.B. aus Silizium, mit einem Fenster 53 versehen wird, in dessen Bereich nur eine dünne Membran 54 bestehen bleibt. Zu diesem Zweck wird die Siliziumscheibe oberflächenseitig mit Bor dotiert, wofür eine Dotierungskonzentration von $1 \times 10^{20}$ Atomen/cm$^3$ vorgesehen sein kann. Beim Ätzen des Fensters 53 bleibt dann der dotierte Teil der Scheibe 52 als Membran 54 übrig. Auf der Scheibe 52 wird sodann ganzflächig eine Plattierelektrode 55, z.B. aus Chrom, aufgedampft, auf der ebenfalls ganzflächig eine erste Fotolackschicht 56 aufgebracht wird. Diese wird anschließend mittels üblicher fotolithografischer Schritte so strukturiert, daß außerhalb der aufzubringenden Abtastelektroden Teile 56, 57 erhalten bleiben. Fig. 8 läßt erkennen, daß an den von den Teilen 56, 57 nicht bedeckten Stellen der Plattierelektrode 55 die Abtastelektroden, z.B. AE und 27, galvanisch aufgebaut werden. Anschließend werden die Teile 56 und 57 entfernt, und die unter denselben liegenden Teile der Plattierelektrode durch Ionenstrahlätzen beseitigt (Fig. 9). Sodann wird eine weitere Fotolackschicht 58 aufgeschleudert und so strukturiert, daß sie außerhalb der gewünschten Ausnehmung 18 usw. bestehen bleibt. Die von 58 nicht bedeckten Teile der Siliziummembran werden schließlich durch Ionenstrahlätzen beseitigt, worauf eine leitende Deckschicht 59 auf der Fotolackschicht 58 aufgebracht wird.

Nach einer Variante des vorstehend beschriebenen Verfahrens kann auf die Ausbildung des Fensters 53 verzichtet werden. In diesem Fall wird nach dem Aufbringen der Fotolackschicht 58 und der Strukturierung derselben ein Ätzvorgang durchgeführt, durch den die Ausnehmung 18 usw. in der in ihrer Dicke vorher nicht reduzierten Halbleiterschicht 52 vor dem Aufbringen der leitenden Deckschicht 59 vorgesehen werden.

Der Erfindungsgedanke umfaßt nicht nur Aperturblenden für Lithografiegeräte, bei denen Elektronenstrahlsonden verwendet werden, sondern auch andere Korpuskularstrahllithografiegeräte, die z.B. mit Ionenstrahlsonden arbeiten

### Bezugszeichenliste

| | |
|---|---|
| 1 | Elektronenstrahlquelle |
| 1a | Kathode |
| 2, 3 | Kondensorlinsen |
| 4 | Aperturblende |
| 4a | weitere Aperturblende |
| 4' | Aperturblende |
| 4a' | Aperturblende |
| 5 | Austastblende |
| 6, 7 | Linsen |
| 8 | Ablenksystem |
| 9 | zu strukturierender Körper |
| 10 | Tisch |
| 11 | Achse |
| 12, 13 | Randstrahlen |
| 14–19 | Ausnehmungen |
| 14a–19a | Ausnehmungen |
| 14b–19b | Elektroden |
| 14c–19c | Elektroden |
| 20 | mittlere Linie |
| 20' | Linie |
| 21–23 | Austastelektroden |
| 24–26 | Anschlüsse |
| 27 | Gegenelektrode |
| 28 | Anschluß |
| 29 | Längsachse |
| 30 | Elektronenstrahlsonde |
| 30a | abgelenkte Elektronenstrahlsonde |
| 31 | Austastelektrode |
| 32 | Ebene |
| 33 | Verkleinerung |
| 34 | Substratfolie |
| 35 | Zwischenstege |
| 36, 37 | Ausnehmungen |
| 36a, 37a | Ausnehmungen |
| 38, 39 | Leiterbahnen |
| 40, 41 | Anschlüsse |
| 43 | Anschluß |
| 44, 45 | Austastelektroden |
| 46, 47 | Anschlüsse |
| 48, 49 | Gegenelektroden |
| 50 | Leiterbahn |
| 51 | Anschluß |
| 52 | Substratscheibe |
| 53 | Fenster |
| 54 | Membran |
| 55 | Plattierelektrode |
| 56 | Fotolackschicht |
| 56, 57 | Teile der Fotolackschicht |
| 58 | Fotolackschicht |
| 59 | Deckschicht |
| OL | Objektivlinse |
| AE | Abtastelektrode |

## Patentansprüche

1. Aperturblende mit zeilenförmiger Mehrlochstruktur und Austastelektroden zur Erzeugung einer Mehrzahl von individuell austastbaren Korpuskularstrahlsonden für ein Lithografiegerät mit einer Korpuskularstrahlquelle (1), einem Kondensorlinsensystem (2, 3), einer Austastblende (5) und einer Abbildungsoptik (6, 7, OL), dadurch gekennzeichnet, daß die Aperturblende (4) aus einem hochohmigen Substrat, insbesondere Silizium oder Siliziumoxid, besteht, auf dem die Austastelektroden in einer senkrecht zur Strahlrichtung orientierten Ebene in Form von Leiterbahenn (21, 23, AE, 27) aufgebracht sind, die mit Anschlüssen (24, 26) für die Zuführung von Austastspannungen versehen sind.

2. Aperturblende nach Anspruch 1, dadurch gekennzeichnet, daß die Mehrlochstruktur der Aperturblende (4) wenigstens annähernd rechteckige oder quadratische Ausnehmungen (14 bis 19) umfaßt, die von einer mittleren Linie (20) ausgehen und jeweils abwechselnd nach der einen und der anderen Seite versetzt sind, und daß an den zu der mittleren Linie (20) parallel liegenden Seiten jeder Ausnehmung Elektroden (21, 23) zur Ablenkung der durch diese Ausnehmung erzeugten Korpuskularstrahlsonde angeordnet sind.

3. Aperturblende nach Anspruch 1, dadurch gekennzeichnet, daß die Mehrlochstruktur wenigstens annähernd rechteckige oder quadratische Ausnehmungen (36, 37) umfaßt, die längs einer Linie angeordnet sind und gegenseitige Abstände aufweisen, die ihren Abmessungen in Richtung der Linie entsprechen, und daß an den zu der Linie parallelen Seiten jeder Ausnehmung Elektroden (38, 39) zur Ablenkung der durch diese Ausnehmung (36, 37) erzeugten Korpuskularstrahlsonde angeordnet sind.

4. Aperturblende nach einem der vorhergehenden Ansprüche, dadurch gekennzeichnet, daß die Leiterbahnen aus Gold bestehen.

5. Aperturblende nach Anspruch 2, dadurch gekennzeichnet, daß die im Bereich der mittleren Linie (20) angeordneten Elektroden einiger oder aller Ausnehmungen (14 ... 19) zu einer gemeinsamen Elektrode (27) zusammengefaßt sind, wobei die Elektroden durch Zwischenstege (35) miteinander verbunden sind.

6. Aperturblende nach einem der Ansprüche 1 bis 5, dadurch gekennzeichnet , daß das Substrat auf der der Korpuskularstrahlquelle (1) zugewandten Seite außerhalb der Mehrlochstruktur mit einer leitenden Belegung zur Ableitung der auftreffenden Korpuskeln versehen ist.

7. Aperturblende nach einem der Ansprüche 2 oder 3, dadurch gekennzeichnet, daß sie durch eine weitere Aperturblende mit weiteren Ausnehmungen ergänzt ist, die ihren Ausnehmungen lagemäßig entsprechen und daß an den senkrecht zur mittleren Linien bzw. Längsrichtung der Mehrlochstruktur verlaufenden Seiten der weiteren Ausnehmungen weitere Elektroden (14b, 14c, 44, 48) vorgesehen sind, die zur Ablenkung der Korpuskularstrahlsonden in Längsrichtung der Mehrlochstruktur dienen.

8. Verfahren zur Herstellung einer Aperturblende nach einem der Ansprüche 1 bis 7, dadurch gekennzeichnet, daß auf einer Substratscheibe (52), insbesondere aus Silizium oder Siliziumoxid, ganzflächig eine Plattierelektrode (55) aufgebracht wird, daß eine auf dieser aufgebrachte erste Fotoleiterschicht so strukturiert wird, daß ihre außerhalb der aufzubringenden Abtastelektroden befindlichen Teile (56, 57) bestehen bleiben, daß anschließend die Abtastelektroden galvanisch auf den Plattierelektroden aufgebaut werden, daß die noch vorhandenen Teile der ersten Fotolackschicht (56, 57) entfernt werden, daß die unter diesen liegenden Teile der Plattierelektrode durch Ionenstrahlätzen beseitigt werden, daß eine zweite Fotolackschicht (58) aufgebracht und so strukturiert wird, daß sie außerhalb der Ausnehmungen (18) der Aperturblende bestehen bleibt, daß die Ausnehmungen (18) durch Ätzen der Siliziumscheibe an den von der zweiten Fotolackschicht nicht bedeckten Stellen erzeugt werden, und daß die zweite Fotolackschicht mit einer leitenden Deckschicht versehen wird.

9. Verfahren nach Anspruch 8, dadurch gekennzeichnet, daß aus der Substratscheibe (52) vor dem Aufbringen der Plattierelektrode im Bereich der Ausnehmungen (18) ein Fenster eingeätzt wird, das bis auf eine dünne oberflächenseitige Membran an die Oberfläche der Substratscheibe (52) heranreicht, und daß nach dem Aufbringen und Strukturieren der zweiten Fotolackschicht (58) die Membran (54) durch eine Ionenstrahlätzung im Bereich der Ausnehmungen (18) entfernt wird.

## Claims

1. Diaphragm with linear multiple-aperture structure and beam blanking electrodes for the production of a multiplicity of individually blankable corpuscular beam probes for a lithography apparatus, having a corpuscular beam source (1), a condenser lens system (2, 3), a beam blanking diaphragm (5) and an optical imaging system (6, 7, OL), characterized in that the diaphragm (4) consists of a highly resistive substrate, especially silicon or silicon dioxide, on which the beam blanking electrodes are applied in a plane oriented perpendicular to the beam direction, in the form of conductor webs (21, 23, AE, 27), which are provided with connections (24, 26) for the supply of beam blanking voltages.

2. Diaphragm according to Claim 1, characterized in that the multiple-aperture structure of the diaphragm (4) comprises at least approximately rectangular or square slots (14 to 19), which proceed from a central line (20) and are respectively offset alternately to the one and to the other side, and in that at the sides of each slot which are disposed parallel to the central line (20) electrodes (21, 23) are disposed for the deflection of the corpuscular beam probe generated by this slot.

3. Diaphragm according to Claim 1, characterized in that the multiple-aperture structure comprises at least approximately rectangular or square slots (36, 37), which are disposed along a line and exhibit mutual spacings which correspond to their dimensions in the direction of the line, and in that at the sides of each slot which are disposed parallel to the line electrodes (38, 39) are disposed for the deflection of the corpuscular beam probe generated by this slot (36, 37).

4. Diaphragm, according to one of the preceding claims, characterized in that the conductor webs consist of gold.

5. Diaphragm according to Claim 2, characterized in that the electrodes, disposed in the region of the central line (20), of some or of all slots (14 ... 19) are combined into a common electrode (27), the electrodes being connected to one another by intermediate bars (35).

6. Diaphragm according to one of Claims 1 to 5, characterized in that the substrate is provided, on the side facing the corpuscular beam source (1), outside the multiple-aperture structure, with a conductive coating to conduct away the impining corpuscles.

7. Diaphragm according to one of Claims 2 or 3, characterized in that it is supplemented by a further diaphragm with further slots, which correspond to its slots in terms of position, and in that at the sides of the further slots extending perpendicular to the central line or longitudinal direction of the multiple-aperture structure further electrodes (14b, 14c, 44, 48) are provided, which serve for the deflection of the corpuscular beam probes in the longitudinal direction of the multiple-aperture structure.

8. Process for the production of a diaphragm according to one of Claims 1 to 7, characterized in that a plating electrode (55) is applied on a substrate plate (52), especially of silicon or silicon dioxide, over the entire surface, in that a first photoconductive layer applied on this plating electrode is structured so that its parts (56, 57) situated outside the scanning electrodes to be applied remain in existence, in that subsequently the scanning electrodes are built up galvanically on the plating electrodes, in that the still present parts of the first photoresist layer (56, 57) are removed, in that the parts of the plating electrode situated beneath these are eliminated by ion beam etching, in that a second photoresist layer (58) is applied and structured so that it remains in existence outside the slots (18) of the diaphragm, in that the slots (18) are formed by etching of the silicon plate at the positions not covered by the second photoresist layer, and in that the second photoresist layer is provided with a conductive covering layer.

9. Process according to Claim 8, characterized in that a window is etched from the substrate plate (52) before the application of the plating electrode in the region of the slots (18), which window reaches, apart from a thin membrane on the surface side, to the surface of the substrate plate (52), and in that after the application and structuring of the second photoresist layer (58) the membrane (54) is removed by an ion beam etching in the region of the slots (18).

**Reventications**

1. Diaphragme d'ouverture comprenant une structure linéaire multitrous et des électrodes d'occultation pour la production de sondes à fisceau corpusculaire pouvant être occultées individuellement, pour un appareil de lithographie possédent une source de rayons corpusculaires (1), un système de lentilles de condenseur (2, 3), un diaphragme d'occultation (5) et une optique de reproduction (6, 7, OL), caractérisé en ce que le diaphragme d'ouverture (4) est formé d'un substrat à forte valeur ohmique, en particulier de silicium ou d'oxyde de silicium, sur lequel les électrodes d'occultation sont disposées, dans un plan perpendiculaire à la direction du faisceau, sous la forme de pistes conductives (21, 23, AE, 27) qui sont munies de bornes (24, 26) pour l'application de tensions d'occultation.

2. Diaphragme selon la revendication 1, caractérisé en ce que la structure multitrous du diaphragme d'ouverture (4) comprend des évidements (14 à 19) qui sont au moins approximativement rectangulaires ou carrés, qui partent d'une ligne médiane (20) et sont décalés alternativement vers l'un et l'autre côté de la ligne, et que des électrodes (21, 23), sont disposées sur les côtés parallèles à la ligne médiane (20) des différents évidements pour la déviation de la sonde à faisceau corpusculaire produite par l'évidement concerné.

3. Diaphragme selon la revendication 1, caractérisé en ce que la structure multitrous comprend des évidements (36, 37) qui sont au moins approximativement rectangulaires ou carrés, sont disposés le long d'une ligne et présentent entre eux des intervalles qui correspondent à leurs dimensions dans le sens de la ligne et que des électrodes (38, 39) sont disposées sur les côtes parallèles à la ligne des différents évidements pour dévier la sonde à faisceau corpusculaire formée par l'évidement (36, 37) concerné.

4. Diaphragme selon une des revendications précédentes, caractétrisé en ce que les pistes conductives sont en or.

5. Diaphragme selon la revendication 2, caractérisé en ce que les électrodes disposées dans la région de la ligne médiane (20) de quelques évidements ou de tous les évidements (14 ... 19) sont réunies en une électrode commune (27) dont les électrodes élémentaires sont reilées entre elles par des parties de liaison (35).

6. Diaphragme selon une des revendications 1 à 5, caractérisé en ce que le substrat est pourvu, sur le côté dirigé vers la source de rayons corpusculaires (1), en dehors de la structure multitrous, d'un revêtement conducteur pour l'évacuation des corpuscules incidents.

7. Diaphragme selon la revendication 2 ou 3, caractérisé en ce qu'il est complété par un diaphragme d'ouverture supplémentaire, présentant d'autres évidements dont les emplacements correspondent aux évidements du diaphragme et que des électrodes supplémentaires (14b, 14c, 44, 48) sont prévues sur les côtés des autres évidements s'étendant perpendiculairement à la ligne médiane ou à la direction longitudinale de la structure multitrous, électrodes supplémentaires qui servent à la déviation des sondes à faisceau corpusculaire dans le sens de la longueur de la structure multitrous.

8. Procédé pour la fabrication d'un diaphragme d'ouverture selon une des revendications 1 à 7, caractérisé en ce qu'il comprend le dépôt d'une électrode de plaquage (55) sur toute la surface d'une rondelle formant substrat (52), en particulier en silicium ou oxyde de silicium, le dépôt sur cette électrode d'une première couche de résine photosensible et la structuration de cette couche de manière que ses parties (56, 57) se trouvant à l'extérieur des électrodes d'occultation à mettre en place soient conservées, la formation galvanique consécutive des électrooles d'occultation sur l'électrode de plaquage, l'enlèvement des parties résiduelles de la première couche de résine photosensible (56, 57), l'élimination par gravure au faisceau ionique des parties de l'électrode de plaquage situées sous elles, le dépôt d'une deuxième souche de résine photosensible (58) et la structuration de cette couche, de manière qu'elle soit conservée en dehors des évidements (18) du diaphragme d'ouverture, la formation des évidements (18) par gravure de la rondelle de silicium aux endroits non recouverts par la deuxième couche de résine photosensible et le dépôt sur cette deuxième couche de résine photosensible d'une couche de recouvrement conductrice.

9. Procédé selon la revendication 8, caractérisé en ce qu'il comprend, avant le dépôt de l'électrode de plaquage, la gravure d'une fenêtre dans la rondelle formant substrat (52), dans la région des évidements (18), fenêtre qui s'étend jusqu'à proximité de la surface de la rondelle formant substrat (52), pour ne laisser subsister qu'une mince membrane située dans ladite surface, et que, à la suite du dépôt et de la structuration de la deuxième couche de résine photosensible (58), il comprend l'élimination de la membrane (54) dans la région des évidements (18) par une gravure au faisceau ionique.

# FIG 1

## FIG 2

## FIG 3

# FIG 4

# FIG 5

FIG 6

FIG 7

FIG 8

FIG 9

FIG 10